(19) Europäisches Patentamt / European Patent Office / Office européen des brevets

(11) **EP 3 315 476 B1**

(12) **EUROPEAN PATENT SPECIFICATION**

(45) Date of publication and mention
of the grant of the patent:
**26.02.2020 Bulletin 2020/09**

(21) Application number: **16814534.0**

(22) Date of filing: **27.06.2016**

(51) Int Cl.:
*C04B 35/111* (2006.01)    *H01L 23/13* (2006.01)
*H01L 23/15* (2006.01)    *C04B 35/119* (2006.01)
*C04B 35/626* (2006.01)    *C04B 35/64* (2006.01)
*C04B 37/02* (2006.01)

(86) International application number:
**PCT/JP2016/069018**

(87) International publication number:
**WO 2016/208766 (29.12.2016 Gazette 2016/52)**

(54) **CERAMIC SUBSTRATE AND MOUNTING SUBSTRATE USING SAME, AND ELECTRONIC DEVICE**

KERAMIKSUBSTRAT UND MONTAGESUBSTRAT DAMIT SOWIE ELEKTRONISCHE VORRICHTUNG

SUBSTRAT CÉRAMIQUE ET SUBSTRAT DE MONTAGE L'UTILISANT ET DISPOSITIF ÉLECTRONIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **26.06.2015 JP 2015128903**

(43) Date of publication of application:
**02.05.2018 Bulletin 2018/18**

(73) Proprietor: **Kyocera Corporation**
**Kyoto 612-8501 (JP)**

(72) Inventors:
• **TANDA, Kenji**
**Kyoto-shi**
**Kyoto 612-8501 (JP)**

• **MIKAKI, Shunji**
**Kyoto-shi**
**Kyoto 612-8501 (JP)**

(74) Representative: **Viering, Jentschura & Partner mbB**
**Patent- und Rechtsanwälte**
**Am Brauhaus 8**
**01099 Dresden (DE)**

(56) References cited:
EP-A1- 1 514 856    EP-A1- 1 845 072
EP-A1- 2 980 042    WO-A1-2013/008920
JP-A- H0 421 564    JP-A- 2000 344 569
JP-A- 2005 211 253    JP-A- 2006 056 746
JP-A- 2010 229 570    JP-A- 2013 199 415
JP-A- 2013 230 949

**Description**

Technical Field

The present disclosure relates to a ceramic substrate according to claim 1, a mounting substrate according to claim 5 and an electronic device according to claim 6.

Background Art

Ceramic substrates are widely used as substrates (mounting substrates) for mounting electronic components via a metal layer.

For example, Patent Document 1 discloses a mounting substrate made of a ceramic substrate containing alumina and zirconia as main components and also containing one or more additive selected from the group consisting of yttria, calcia, magnesia, and ceria.

Citation List

Patent Literature

Patent Document 1: JP 08-195450 A

Summary of Invention

The ceramic substrate of the present disclosure contains alumina crystals and zirconia crystals. A mass ratio of A to B is from 89:11 to 93:7, where A is a mass of alumina, and B is a total mass of a stabilizer component, hafnia, and zirconia. Further, an average crystal grain size of alumina crystals is not less than 1.0 $\mu$m and not greater than 1.5 $\mu$m, and an average crystal grain size of zirconia crystals is not less than 0.3 $\mu$m and not greater than 0.5 $\mu$m.

Brief Description of Drawings

FIG. 1 is a plan view illustrating an example of a mounting substrate of the present disclosure.
FIG. 2 is a cross-sectional view of the mounting substrate illustrated in FIG. 1.
FIG. 3 is a plan view illustrating an example of an electronic device of the present disclosure.
FIG. 4 is a cross-sectional view of the electronic device illustrated in FIG. 3.

Description of Embodiments

A known type of ceramic substrate used in a mounting substrate is an alumina substrate containing zirconia (zirconia-toughened alumina substrate: ZTA substrate).

Here, due to the continually increasing output of electronic components in recent years, the amount of heat generated at the time of output of electronic components has become large. Therefore, the ceramic substrate used to form a mounting substrate is itself required to have excellent discharge characteristics, that is, to have a high coefficient of thermal conductivity.

On the other hand, in a case where a ceramic substrate is formed with a composition which emphasizes on discharge characteristics, the mechanical strength tends to be diminished, which reduces the reliability of the ceramic substrate as a mounting substrate. In addition, when the mechanical strength is low, a reduction in thickness of the mounting substrate, which has been in demand in recent years, also cannot be achieved. Therefore, a ceramic substrate is required to have both a high coefficient of thermal conductivity and high mechanical strength.

The ceramic substrate, mounting substrate using the same, and electronic device of the present disclosure will be described in detail hereinafter with reference to the drawings.

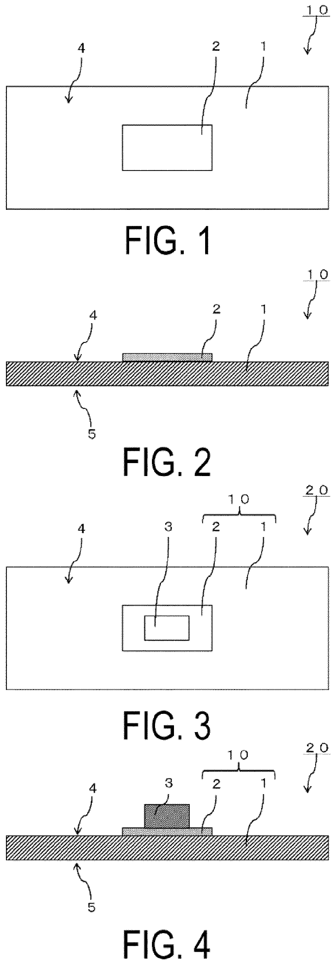

FIG. 1 is a plan view illustrating an example of a mounting substrate of the present disclosure. FIG. 2 is a cross-sectional view of the mounting substrate illustrated in FIG. 1.

A mounting substrate 10 of the example illustrated in FIG. 1 includes a ceramic substrate 1 and a metal layer 2. In addition, as illustrated in FIG. 2, the ceramic substrate 1 includes a pair of a first surface 4 and a second surface 5 in a thickness direction. In other words, the first surface 4 is located on the opposite side of the second surface 5. The second surface 5 is located on the opposite side of the first surface 4. The metal layer 2 is located on the first surface 4. Note that in FIG. 1, an example in which the metal layer 2 is located on the first surface 4 is illustrated, but the metal layer 2 is only required to be located on at least one of the first surface 4 or the second surface 5. In addition, the metal layer 2 may also be located on both the first surface 4 and the second surface 5.

The ceramic substrate of the present disclosure will be described hereinafter. The ceramic substrate 1 contains alumina crystals and zirconia crystals. A mass ratio (A:B) of a mass A of alumina ($Al_2O_3$) and a mass B including a stabilizer component, hafnia ($HfO_2$), and zirconia ($ZrO_2$) is from 89:11 to 93:7. Further, an average crystal grain size of alumina is not less than 1.0 $\mu$m and not greater than 1.5 $\mu$m, and an average crystal grain size of zirconia is not less than 0.3 $\mu$m and not greater than 0.5 $\mu$m. Since the ceramic substrate 1 of the present disclosure satisfies such a configuration, the ceramic substrate 1 has both a high coefficient of thermal conductivity and high mechanical strength. Note that the stabilizer component, hafnia, and zirconia are collectively referred to as "zirconias" hereafter.

Here, a high coefficient of thermal conductivity means that a value determined by the laser flash method according to JIS R1611-2010 is not less than 20 W/m·K. In addition, a high mechanical strength means that a value of the three-point bending strength according to JIS R 1601-2008 is not less than 600 MPa. Note that when the mass ratio of the mass A of alumina is less than 89 (the mass ratio of the mass B of zirconias exceeds 11), a high coefficient of thermal conductivity is not achieved. In addition, when the mass ratio of the mass A of alumina exceeds 93 (the mass ratio of the mass B of zirconias is less than 7), a high mechanical strength is not achieved.

Further, when the average crystal grain size of alumina is less than 1.0 $\mu$m, a high coefficient of thermal conductivity is not achieved as the grain boundary phase increases. In addition, when the average crystal grain size of alumina exceeds 1.5 $\mu$m, a high mechanical strength is not achieved. Further, when the average crystal grain size of zirconia is less than 0.3 $\mu$m, heat transfer between crystals is obstructed due to increases in the grain boundary, thus, a high coefficient of thermal conductivity is not achieved. In addition, when the average crystal grain size of zirconia exceeds 0.5 $\mu$m, a high mechanical strength is not achieved.

The average crystal grain size of alumina may be not less than 1.2 $\mu$m and not greater than 1.4 $\mu$m. In this case, zirconia crystals of the size described above are present at triple points among the alumina crystals constituting a greater portion of the ceramic substrate 1, which results in a dense crystal arrangement. Therefore, the ceramic substrate 1 demonstrates both an even higher coefficient of thermal conductivity and even higher mechanical strength. Note that an even denser crystal arrangement is achieved when the average crystal grain size of zirconia is not less than 0.35 $\mu$m and not greater than 0.45 $\mu$m.

In addition, the standard deviation of the crystal grain size of alumina in the ceramic substrate 1 of the present disclosure is not greater than 0.7. In this case, the variation in the crystal grain size of the alumina constituting a greater portion of the ceramic substrate 1 is small, and the crystal arrangement of the ceramic substrate 1 is nearly made uniform. Therefore, the ceramic substrate 1 demonstrates both an even higher coefficient of thermal conductivity and even higher mechanical strength.

In addition, a ratio of monoclinic crystals in the zirconia crystals may be not less than 3.0% and not greater than 6.0%. In this case, the generation of microcracks is suppressed at the time of phase transformation into monoclinic crystals, and the compressive stress imposed on the alumina crystals by the monoclinic crystals of the zirconia crystals that are present yields a higher mechanical strength. The propagation of cracks generated in the ceramic substrate 1 can also be suppressed by the compressive stress applied to the ceramic substrate 1. Note that the ratio of monoclinic crystals is determined with respect to the total amount of tetragonal crystals, cubic crystals, and monoclinic crystals.

In addition, the average value of the distances between the centers of gravity of every two neighboring zirconia crystals may be not less than 1.8 $\mu$m and not greater than 3.2 $\mu$m. In this case, the zirconia crystals are dispersed moderately, so the variation in mechanical strength is suppressed, and the reliability of the ceramic substrate 1 increases. Note that the average value of the distance between the centers of gravity described here is the average value of the shortest distance between the centers of gravity of each of the adjacent zirconia crystals. That is, the average value of the distance between the centers of gravity is an index representing the degree of dispersion between zirconia crystals.

The ceramic substrate 1 of the present disclosure also exhibits excellent reflectance because zirconia crystals, which have a higher index of refraction than alumina, are present between the alumina crystals constituting a greater portion of the ceramic substrate 1. Therefore, the ceramic substrate 1 of the present disclosure can be suitably used as a mounting substrate for an electronic component which requires high brightness, specifically, a light-emitting diode (LED) element.

Next, the components other than alumina and zirconia will be described. First, the stabilizer component of zirconia is one or two types selected from strontia (SrO), yttria ($Y_2O_3$), ceria ($CeO_2$), scandia ($SC_2O_3$), dysprosia ($Dy_2O_3$), and the like. When the stabilizer component is yttria, in particular, the ion radius is similar to that of zirconia, so the degree of stabilization is high, and coarse crystals of zirconia are unlikely to generate. Therefore, the mechanical strength of the ceramic substrate 1 can be further enhanced. Note that the stabilizer component may be contained within a range of not less than 1 mol% and not greater than 12 mol% per 100 mol% of zirconia. For example, when the stabilizer component is yttria, the stabilizer component may be contained within a range of not less than 1 mol% and not greater than 5 mol% per 100 mol% of zirconia.

In addition, hafnia is contained within a range of not less than 1 part by mass and not greater than 3 parts by mass per 100 parts by mass of zirconia.

Further, the ceramic substrate 1 of the present disclosure may also contain a sintering aid component such as silica ($SiO_2$), magnesia (MgO), or calcia (CaO) to increase sinterability as a component other than alumina and zirconias. Note that the sintering aid component is preferably contained within a range of not less than 0.1 parts by mass and not greater than 2.0 parts by mass per total of 100 parts by mass of alumina and zirconias.

In addition, when at least silica is contained as a sintering aid component and the content of the sintering aid is within the range described above, glass is formed in the grain boundary phase. When a paste which forms the metal layer 2 contains a glass component, the wettability is improved between the surface of the ceramic substrate 1 and the paste which forms the metal layer 2, so the adhesion strength between the ceramic substrate 1 and the metal layer 2 is enhanced.

Next, examples of various measurement methods will be described.

The contents of alumina, the stabilizer component, hafnia, zirconia, and the sintering aid component may be calculated by the following method. First, a qualitative analysis of the ceramic substrate 1 is performed using an energy dispersive spectrometer (EDS) attached to an X-ray fluorescence spectrometer (XRF) or a scanning electron microscope (SEM). Next, the elements detected by this qualitative analysis are subjected to quantitative analysis using an ICP emission spectrophotometer (ICP). Next, the contents of alumina, the stabilizer component, hafnia, zirconia, and the sintering aid component may be calculated by converting the content of each element measured by this quantitative analysis to a value in terms of oxide.

In addition, the mass ratio of the mass A of alumina and the mass B including a stabilizer component, hafnia, and zirconia is calculated as follows. First, the contents determined by the method described above are used to determine the mass A and the mass B. The mass ratio of the mass A may then be determined by (mass A/(mass A + mass B)$\times$100, and the mass ratio of the mass B may be determined by (mass B/(mass A + mass B))$\times$100. Note that once the mass ratio of the mass A is calculated, the mass B may be determined by subtracting the mass A from 100.

Next, the measurement method for the average crystal grain size of alumina and zirconia will be described. First, the surface of the ceramic substrate 1 is subjected to mirror finishing and is heat-treated in a temperature range from 50 to 100°C lower than the firing temperature. The heat-treated surface is then used as a measurement surface and is photographed at a multiplication factor of 5000 times using an SEM. Next, the photographed image data is analyzed using image analysis software (for example, Win ROOF available from the Mitani Corporation). As a result, the data for the respective crystal grain sizes of alumina and zirconia present in the image data can be obtained.

Note that although the ceramic substrate 1 may contain crystals with a crystal grain size of less than 0.05 $\mu$m, only crystals with a crystal grain size of at least 0.05 $\mu$m are targeted in the analysis by the image analysis software described above. In addition, when image analysis software such as that described above is used, separate measurements are possible because there is a difference in color tone between alumina crystal grains and zirconia crystal grains. The average value of an equivalent circle diameter of each crystal grain calculated from the area of each crystal grain of alumina is the average crystal grain size of alumina, and the average value of an equivalent circle diameter of each crystal grain calculated from the area of each crystal grain of zirconia is the average crystal grain size of zirconia.

In addition, the standard deviation of the crystal grain size of alumina can be determined by the same method as that used to determine the average crystal grain size described above from the data of the crystal grain size of alumina obtained using image analysis software.

Further, the ratio of monoclinic crystals in the zirconia crystals can be determined by measuring the surface of the ceramic substrate 1 with an X-ray diffractometer (XRD) and using the resulting X-ray diffraction intensity in the following equations.

$$\text{Ratio (\%) of monoclinic crystals} = (Im1 + Im2)/(Im1 + Im2 + It + Ic)$$

It: X-ray diffraction intensity of the tetragonal (111) plane
Ic: X-ray diffraction intensity of the cubic (111) plane
Im1: X-ray diffraction intensity of the monoclinic (111) plane
Im2: X-ray diffraction intensity of the monoclinic (11-1) plane

In addition, The average value of the distance between the centers of gravity of every two neighboring zirconia crystals can be calculated using the same image data as that used to determine the average crystal grain size described above. Specifically, "Azo-kun" (trade name, available from the Asahi Kasei Engineering Cooperation) is used as image analysis software, and the average value of the distance between centers of gravity may be calculated using a technique called the center of gravity distance method of "Azo-kun". Here, as the analysis conditions, it is sufficient to set the lightness of grains to "light", the binarization method to "manual", the small figure removal to "0.05 $\mu$m", and the threshold value to "220".

In addition, when the thickness of the test piece is small, the value of the resulting coefficient of thermal conductivity becomes large. Therefore, the coefficient of thermal conductivity of the ceramic substrate 1 of the present disclosure is determined for a cylindrical test piece having a diameter of 100 mm and a thickness of 2 mm and is determined by the laser flash method according to JIS R1611-2010 after the density is determined by Archimedes' method using this test piece.

Further, the mechanical strength is determined by preparing a test piece with a shape according to JIS R 1601-2008 and performing a three-point bending strength test in accordance with JIS R 1601-2008.

The mounting substrate 10 of the present disclosure includes the ceramic substrate 1 of the present disclosure described above and a metal layer 2 located on at least the first surface 4 or the second surface 5 of the ceramic substrate 1. The coefficient of thermal conductivity of the ceramic substrate 1 itself is high, and the mounting substrate 10 is configured to include a metal layer 2, which enables the mounting of high-output electronic components. Further, the mounting substrate 10 can withstand use over a long period of time due to the high mechanical strength of the ceramic substrate 1. In addition, the high mechanical strength also makes it possible to accommodate a reduction in the thickness of the ceramic substrate 1.

FIG. 3 is a plan view illustrating an example of the electronic device of the present disclosure, and FIG. 4 is a cross-sectional view of the electronic device illustrated in FIG. 3. The electronic device 20 in the example illustrated in FIGS. 3 and 4 includes an electronic component 3 provided on the metal layer 2 of the mounting substrate 10 made of the ceramic substrate 1 and the metal layer 2 located on the first surface 4 of the ceramic substrate 1. Note that a wiring layer made of metal may be formed in a region other than the metal layer 2 on the first surface 4 of the ceramic substrate 1. In addition, on the second surface 5 of the ceramic substrate 1, a metal layer may be formed via a joint layer, or a heat sink or a flow path member may be further formed.

Since the electronic device 20 of the present disclosure sufficiently exhibits the characteristics of the electronic component 3 and can be used over a long period of time, the electronic device 20 is highly reliable.

Here, the electronic component 3 provided on the metal layer 2 of the mounting substrate 10 may be used, for example, in a semiconductor element such as an insulated gate bipolar transistor (IGBT) element, an intelligent power module (IPM) element, a metal oxide semiconductor field effect transistor (MOSFET) element, an LED element, a freewheeling diode (FWD) element, a giant transistor (GTR) element, or a Schottky barrier diode (SBD). In addition, the electronic component 3 may be used in a heat-generating element for a sublimation type thermal printer head or a thermal inkjet printer head. Further, the electronic component may be used in a Peltier element.

Next, an example of the manufacturing method for the ceramic substrate 1 of the present disclosure will be described.

First, a first alumina power having an average grain size of not less than 0.9 $\mu$m and not greater than 1.3 $\mu$m, a second alumina powder having an average grain size of not less than 0.3 $\mu$m and not greater than 0.7 $\mu$m, a zirconia powder containing not less than 1 mol% and not greater than 5 mol% of yttria as a stabilizer component, and silica power having an average grain size of approximately 0.5 $\mu$m as sintering aid are prepared as raw materials. Note that the zirconia powder has an average grain size of not less than 0.1 $\mu$m and not greater than 0.3 $\mu$m and contains 2 parts by mass of hafnia per 100 parts by mass of zirconia.

The first alumina powder and the second alumina powder are then weighed so that the mass ratio is from 40:60 to 80:20 and so that the mass ratio of alumina and zirconia including the stabilizer component and hafnia in the ceramic substrate 1 is from 89:11 to 93:7. Note that the added amount of the sintering aid component is not less than 0.1 parts by mass and not greater than 2.0 parts by mass per total of 100 parts by mass of alumina and zirconias.

Here, in order to keep the standard deviation of the crystal grain size of alumina to not greater than 0.7, it is sufficient that the mass ratio of the first alumina powder and the second alumina powder be within the range of from 50:50 to 70:30.

A slurry is then obtained by placing the weighed powders, a solvent such as water containing a dispersing agent, and high-purity alumina balls or zirconia balls in a tumbling mill and then mixing and pulverizing the components.

Here, in order to ensure that the average value of the distance between the centers of gravity of every two neighboring zirconia crystals is not less than 1.8 $\mu$m and not greater than 3.2 $\mu$m, it is sufficient that the added amount of the dispersing agent be not less than 0.07 parts by mass and not greater than 0.20 parts by mass per 100 parts by mass of the weighed powders.

Next, a green sheet is obtained by a doctor blade method using this slurry. Alternatively, using a granulated body prepared by spray-drying the slurry using a spray dryer, a green sheet is obtained by a powder press molding method or a roller compaction method.

Next, a compact is obtained by performing profile shape machining with a metal mold or a laser. Note that the green sheet may be used directly as a compact and subjected to profile shape machining with a laser after being subject to firing. In addition, taking into consideration mass productivity, a multipiece compact is preferably used.

Next, the ceramic substrate 1 of the present disclosure may be obtained by firing the obtained compact using a firing furnace with an atmospheric (oxidizing) atmosphere (for example, a roller-type tunnel furnace, a batch-type atmosphere furnace, or a pressure-type tunnel furnace) so that the maximum temperature is within the range of from 1530 to 1600°C.

In addition, the ratio of monoclinic crystals in the zirconia crystals may be adjusted to not less than 3.0% and not greater than 6.0% by performing surface treatment on the ceramic substrate 1. Specifically, performing surface treatment on the ceramic substrate 1 promotes phase transformation in the tetragonal or cubic crystals of the zirconia crystals and thereby increases the ratio of monoclinic crystals in the zirconia crystals. A method of surface treatment is grinding/polishing treatment, which entails grinding or polishing the surface of the ceramic substrate 1 with a diamond grindstone. Another method is heat treatment, which entails leaving the ceramic substrate 1 to stand at a high temperature and then allowing the ceramic substrate 1 to cool rapidly. Yet another method is blast treatment or the like, which entails blowing an abrasive grain such as a ceramic, diamond, or metal against the ceramic substrate 1.

Since the ceramic substrate 1 of the present disclosure is fired at a high maximum temperature of from 1530 to 1600°C using two types of alumina powders of different average grain sizes having the sizes described above and a zirconia powder of the size described above, the ceramic substrate 1 exhibits both a high coefficient of thermal conductivity and high mechanical strength. Note that although the reason that such an effect can be demonstrated is unclear, the reason lies in the dense crystal arrangement from the perspective of the coefficient of thermal conductivity. From the perspective of mechanical strength, the effect may originate from the following when the average crystal grain size of alumina is not less than 1.0 $\mu$m and not greater than 1.5 $\mu$m. Whereas the first alumina crystals made of the first alumina powder do not exhibit substantial grain growth, the second alumina crystals made of the second alumina powder exhibit grain growth, and the grain growth of the second alumina crystals provides compressive stress to the first alumina crystals. In addition, due to the size relationship among the first alumina powder, the second alumina powder, and the zirconia powder, the zirconia powder tends to be present in a dispersed state, and the grain growth of zirconia crystals which are present in a dispersed state provide compressive stress to the alumina crystals. The ceramic substrate 1 exhibits high mechanical strength because the alumina crystals are in a state of withstanding compressive stress in this way.

In addition, in order to ensure that the average crystal grain size of alumina is not less than 1.2 $\mu$m and not greater than 1.4 $\mu$m, it is sufficient that the maximum temperature for firing is within the range of from 1540 to 1590°C.

The specific thickness of the ceramic substrate 1 is not greater than 2 mm, and when the ceramic substrate 1 of the present disclosure is a substrate used for the mounting of an electronic component, the substrate can accommodate a thickness of 0.2 mm.

Next, an example of a manufacturing method for mounting substrate 10 of the present disclosure will be described.

First, the ceramic substrate 1 described above is prepared. In addition, a metal paste containing at least one type of copper, aluminum, or silver as a main component is prepared as a metal layer 2. Here, copper is preferably used as the main component when taking cost into consideration and when higher discharge characteristics are required. The metal paste is applied to at least the first surface 4 or the second surface 5 of the ceramic substrate 1 using a printing method and is then heat-treated to form a metal layer 2. Note that the metal layer 2 may also be formed by metal plate joining or metal plate direct joining using a plating method or an active metal method. In addition, the metal layer 2 may also be formed into a prescribed shape by etching after the metal layer 2 is first formed to be wider than the prescribed shape. By forming the metal layer 2 on at least the first surface 4 or the second surface 5 of the ceramic substrate 1 in this way, a mounting substrate 10 can be obtained.

In addition, some or all of the surface of the metal layer 2 may be subjected to plating treatment. By performing plating treatment in this way, the oxidation corrosion of the metal layer 2 can be suppressed. Any known type of plating may be used, and examples thereof include gold plating, silver plating, nickel-gold plating, and the like.

Further, the electronic device 20 of the present disclosure can be obtained by mounting the electronic component 3 on the metal layer 2 of the mounting substrate 10 described above.

Hereinafter, specific descriptions of examples of the present disclosure are given, but the present disclosure is not limited to these examples.

Example 1

Samples of various different configurations were prepared, and the coefficient of thermal conductivity and the three-point bending strength were measured. First, a first alumina power having an average grain size of 1.0 $\mu$m, a second alumina powder having an average grain size of 0.5 $\mu$m, a zirconia powder containing 3 mol% of yttria as a stabilizer component, and silica powder having an average grain size of 0.5 $\mu$m as a sintering aid were prepared as raw materials. Note that the zirconia powder has an average grain size of 0.2 $\mu$m and contains 2 parts by mass of hafnia per 100 parts by mass of zirconia.

The first alumina powder and the second alumina powder were then weighed so that the mass ratio was a value shown in Table 1 and the mass ratio of alumina and zirconias in the ceramic substrate was 92:8. Note that the added amount of the sintering aid component was 0.5 parts by mass per total of 100 parts by mass of alumina and zirconias.

Next, a slurry was obtained by placing the weighed powders, water containing a dispersing agent, and high-purity alumina balls in a tumbling mill and then mixing and pulverizing the components. Here, the added amount of the dispersing agent was 0.03 parts by mass per 100 parts by mass of the weighed powders.

Next, using a granulated body prepared by spray-drying the slurry using a spray dryer, a compact was obtained by a powder press molding method. A sintered compact was then obtained by firing the obtained compact at a firing temperature shown in Table 1 using a roller-type tunnel furnace with an atmospheric (oxidizing) atmosphere. The obtained sample was then subjected to grinding to obtain a sample for coefficient of thermal conductivity measurement having a diameter of 10 mm and a thickness of 2 mm and a sample for three-point bending strength measurement having a width of 4 mm, a thickness of 3 mm, and a length of 30 mm.

After the density was determined by Archimedes' method using the sample for coefficient of thermal conductivity measurement, the coefficient of thermal conductivity was determined by the laser flash method according to JIS R1611-2010.

In addition, the sample for three-point bending strength measurement was used to determine the three-point bending strength in accordance with JIS R 1601-2008.

Further, by measuring a portion of each sample by ICP and converting the result to a value in terms of oxide, the contents of alumina, the stabilizer component, hafnia, zirconia, and the sintering aid component were determined. The mass ratio of the mass A was determined by (mass A/(mass A + mass B)$\times$100 and the mass ratio of the mass B was determined by (mass B/(mass A + mass B))$\times$100 using the total mass of the mass A of alumina and the mass B of zirconias as a denominator. The mass ratio of the mass A and the mass B was 92:8 in each of the samples.

In addition, the surface of each of the obtained samples was subjected to mirror finishing and was heat-treated at a temperature 70°C lower than the firing temperature. The heat-treated surface was then used as a measurement surface and was photographed at a multiplication factor of 5000 times using an SEM. The photographed image data was analyzed using image analysis software to calculate the average crystal grain sizes of alumina and zirconia. The results are shown in Table 1.

Table 1

| Sample No. | Mass ratio | | Alumina First: second | Firing temperature °C | Average crystal grain size | | Coefficient of thermal conductivity W/m·K | Three-point bending strength MPa |
| | Alumina Mass A | Zirconias Mass B | | | Alumina $\mu$m | Zirconia $\mu$m | | |
| --- | --- | --- | --- | --- | --- | --- | --- | --- |
| 1 | 92 | 8 | 90:10 | 1560 | 1.2 | 0.6 | 20 | 580 |
| 2 | 92 | 8 | 60:40 | 1500 | 0.9 | 0.28 | 17 | 539 |
| 3 | 92 | 8 | 60:40 | 1530 | 1.0 | 0.30 | 21 | 611 |
| 4 | 92 | 8 | 60:40 | 1560 | 1.2 | 0.35 | 22 | 645 |
| 5 | 92 | 8 | 60:40 | 1575 | 1.3 | 0.40 | 23 | 633 |
| 6 | 92 | 8 | 60:40 | 1590 | 1.4 | 0.45 | 23 | 620 |
| 7 | 92 | 8 | 60:40 | 1600 | 1.5 | 0.50 | 24 | 605 |
| 8 | 92 | 8 | 60:40 | 1610 | 1.6 | 0.52 | 24 | 592 |

As shown in Table 1, in Sample Nos. 1, 2, and 8, which failed to satisfy at least one of the conditions of the average crystal grain size of alumina being not less than 1.0 $\mu$m and not greater than 1.5 $\mu$m or the average crystal grain size of zirconia being not less than 0.3 $\mu$m and not greater than 0.5 $\mu$m, the coefficient of thermal conductivity was less than 20 W/m·K or the three-point bending strength was less than 600 MPa. In contrast, it can be seen that in Sample Nos. 3 to 7, the coefficient of thermal conductivity was not less than 20 W/m·K and the three-point bending strength was not less than 600 MPa, and the average crystal grain size of alumina was not less than 1.0 $\mu$m and not greater than 1.5 $\mu$m, while the average crystal grain size of zirconia was not less than 0.3 $\mu$m and not greater than 0.5 $\mu$m, so Sample Nos. 3 to 7 exhibited both a high coefficient of thermal conductivity and high mechanical strength.

In addition, it can be seen that the average crystal grain size of alumina is preferably not less than 1.2 $\mu$m and not greater than 1.4 $\mu$m.

Example 2

Samples of different mass ratios of the mass A and the mass B were prepared, and the coefficient of thermal conductivity and the three-point bending strength were measured. Note that each sample was prepared with the same method as in the case of Sample No. 5 described in Example 1 with the exception that the mass ratio of the mass A and the mass B was set to the value shown in Table 2. Sample No. 13 is the same sample as Sample No. 5.

The coefficient of thermal conductivity and the three-point bending strength were measured with the same methods as in Example 1. In addition, the mass ratio of the mass A and the mass B was determined with the same method as in Example 1. The results are shown in Table 2.

Table 2

| Sample No. | Mass ratio | | Coefficient of thermal conductivity W/m·K | Three-point bending strength MPa |
| --- | --- | --- | --- | --- |
| | Alumina Mass A | Zirconias Mass B | | |
| 9 | 88 | 12 | 18 | 664 |
| 10 | 89 | 11 | 21 | 661 |
| 11 | 90 | 10 | 22 | 653 |
| 12 | 91 | 9 | 23 | 646 |
| 13 | 92 | 8 | 23 | 633 |
| 14 | 93 | 7 | 24 | 619 |
| 15 | 94 | 6 | 24 | 587 |

As shown in Table 2, in Sample No. 9 in which the mass ratio of the mass A of alumina was less than 89 (the mass ratio of the mass B of zirconias exceeded 11), the coefficient of thermal conductivity was less than 20 W/M·K. In addition, in Sample No. 15 in which the mass ratio of the mass A of alumina exceeded 94 (the mass ratio of the mass B of zirconias was less than 7), the three-point bending strength was less than 600 MPa. In contrast, it can be seen that in Sample Nos. 10 to 14, the coefficient of thermal conductivity was not less than 20 W/m·K and the three-point bending strength was not less than 600 MPa, and mass ratio of the mass A and the mass B was from 89:11 to 93:7, so sample Nos. 10 to 14 exhibited both a high coefficient of thermal conductivity and high mechanical strength.

Example 3

Samples of different mass ratios of the first alumina powder and the second alumina powder were prepared, and the coefficient of thermal conductivity and the three-point bending strength were measured. Note that each sample was prepared with the same method as in the case of Sample No. 5 described in Example 1 with the exception that the mass ratio of the first alumina powder and the second alumina powder was set to the value shown in Table 3. Sample No. 18 is the same sample as Sample No. 5.

The coefficient of thermal conductivity and the three-point bending strength were measured with the same methods as in Example 1. The results are shown in Table 3.

Table 3

| Sample No. | Alumina First: Second | Standard deviation | Coefficient of thermal conductivity W/m·K | Three-point bending strength MPa |
| --- | --- | --- | --- | --- |
| 16 | 80:20 | 0.8 | 20 | 603 |
| 17 | 70:30 | 0.7 | 21 | 614 |
| 18 | 60:40 | 0.6 | 23 | 633 |
| 19 | 50:50 | 0.7 | 22 | 621 |
| 20 | 40:60 | 1.0 | 21 | 601 |

It can be seen from the results shown in Table 3 that in order to keep the standard deviation of the crystal grain size of alumina to not greater than 0.7, it is sufficient that the mass ratio of the first alumina powder and the second alumina powder is within the range of from 50:50 to 70:30, and keeping the mass ratio within this range enables the sample to exhibit both a high coefficient of thermal conductivity and high mechanical strength.

Example 4

In order to vary the ratio of monoclinic crystals in the zirconia crystals, samples subjected to surface treatment were prepared, and the three-point bending strength was measured. Note that each sample was prepared with the same method as in the case of Sample No. 5 described in Example 1 with the exception that blast treatment was performed on the surface of the sintered compact using a commercially available jet blaster so that the monoclinic crystal ratio (ratio of monoclinic crystals in the zirconia crystals) shown in Table 4 was achieved. Sample No. 21 is the same sample as Sample No. 5.

Here, the monoclinic crystal ratio of each sample was determined by measuring the surface of each sample with an XRD and using the resulting X-ray diffraction intensity in the equations below.

$$\text{Monoclinic crystal ratio (\%)} = (Im1 + Im2)/(Im1 + Im2 + It + Ic)$$

It: X-ray diffraction intensity of the tetragonal (111) plane
Ic: X-ray diffraction intensity of the cubic (111) plane
Im1: X-ray diffraction intensity of the monoclinic (111) plane
Im2: X-ray diffraction intensity of the monoclinic (11-1) plane

The three-point bending strength was measured with the same method as in Example 1. The results are shown in Table 4.

Table 4

| Sample No. | Monoclinic crystal ratio % | Three-point bending strength MPa |
|---|---|---|
| 21 | 0.5 | 633 |
| 22 | 3.0 | 654 |
| 23 | 4.5 | 672 |
| 24 | 6.0 | 663 |
| 25 | 7.0 | 641 |

It can be seen from the results shown in Table 4 that in Sample Nos. 22 to 24, the three-point bending strength was not less than 650 MPa, and the monoclinic crystal ratio in the zirconia crystals was not less than 3.0% and not greater than 6.0%, so the samples exhibited higher mechanical strength.

Example 5

Samples of different added amounts of dispersing agents were prepared, and the three-point bending strength was measured. Note that each sample was prepared with the same method as in the case of Sample No. 23 described in Example 4 with the exception that the added amount of the dispersing agent was set to the value shown in Table 5. Sample No. 30 is the same sample as Sample No. 23. Note that even when the added amount of the dispersing agent was made larger than 0.20 parts by mass per 100 parts by mass of the weighed powders, the average distance between the centers of gravity remained unchanged and was not smaller than 1.8 μm.

Here, the average value of the distance between the centers of gravity of every two neighboring zirconia crystals in each sample was calculated by acquiring image data with the same method as that used to determine the average crystal grain size in Example 1 and analyzing the image data using a technique called the center of gravity distance method of the image analysis software "Azo-kun". Here, as the analysis conditions, the lightness of grains was set to "light", the binarization method was set to "manual", the small figure removal was set to "0.05 μm", and the threshold value was set to "220".

The three-point bending strength was measured with the same method as in Example 1. The results are shown in Table 5. Note that in Table 5, the "average value of the distance between centers of gravity of every two neighboring zirconia crystals" is expressed as the "average distance between centers of gravity".

Table 5

| Sample No. | Dispersing agent Parts by mass | Average distance between centers of gravity μm | Three-point bending strength MPa |
|---|---|---|---|
| 26 | 0.20 | 1.8 | 713 |
| 27 | 0.13 | 2.0 | 711 |
| 28 | 0.10 | 2.5 | 705 |
| 29 | 0.07 | 3.2 | 689 |
| 30 | 0.03 | 4.1 | 672 |

As shown in Table 5, it can be seen that in Sample Nos. 26 to 29, the three-point bending strength was not less than 680 MPa, and the average value of the distance between the centers of gravity of every two neighboring zirconia crystals was not less than 1.8 μm and not greater than 3.2 μm, so variation in the mechanical strength was suppressed.

In addition, the mounting substrate of the present disclosure includes the ceramic substrate of the present disclosure, which exhibits both a high coefficient of thermal conductivity and high mechanical strength, and a metal layer. Therefore, it was determined that the mounting substrate of the present disclosure enables the mounting of high-output electronic components and can withstand use over a long period of time due to the high mechanical strength of the ceramic substrate. Further, the electronic device of the present disclosure is prepared by mounting an electronic component on the mounting substrate of the present disclosure. Therefore, since the electronic device of the present disclosure sufficiently exhibits the characteristics of the electronic component and can be used over a long period of time, it can be seen that the electronic device is highly reliable.

Reference Signs List

1 Ceramic substrate
2 Metal layer
3 Electronic component
4 First surface
5 Second surface
10 Mounting substrate
20 Electronic device

**Claims**

1.    A ceramic substrate comprising:

   alumina crystals; and
   zirconia crystals,
   wherein components are alumina, zirconias containing a stabilizer component, hafnia and zirconia, and a sintering aid component;
   a mass ratio of A to B is from 89:11 to 93:7, where A is a mass of alumina, and B is a total mass of the zirconias;
   the sintering aid component is contained within a range of not less than 0.1 parts by mass and not greater than 2.0 parts by mass per total of 100 parts by mass of A and B;
   an average crystal grain size of the alumina crystals is not less than 1.0 μm and not greater than 1.5 μm ;
   an average crystal grain size of the zirconia crystals is not less than 0.3 μm and not greater than 0.5 μm; and
   a standard deviation of the crystal grain size of the alumina crystals is not greater than 0.7.

2.    The ceramic substrate according to claim 1, wherein the average crystal grain size of the alumina crystals is not less than 1.2 μm and not greater than 1.4 μm.

3. The ceramic substrate according to claim 1 or 2,
wherein a ratio of monoclinic crystals in the zirconia crystals is not less than 3.0% and not greater than 6.0%.

4. The ceramic substrate according to any one of claims 1 to 3, wherein an average value of distances between centers of gravity of every two neighboring zirconia crystals is not less than 1.8 $\mu$m and not greater than 3.2 $\mu$m.

5. A mounting substrate comprising:

the ceramic substrate according to any one of claims 1 to 4; and
a metal layer located on the ceramic substrate.

6. An electronic device comprising:

the mounting substrate according to claim 5; and
an electronic component located on the metal layer of the mounting substrate.


**Patentansprüche**

1. Keramiksubstrat, aufweisend:

Aluminiumoxidkristalle und
Zirconiumdioxidkristalle,
wobei Komponenten Aluminiumoxid, Zirkonias, die eine Stabilisatorkomponente enthalten, Hafniumoxid und Zirconiumdioxid enthalten und eine Sinterhilfsmittelkomponente sind,
ein Massenverhältnis von A zu B von 89:11 bis 93:7 beträgt, wobei A eine Masse von Aluminiumoxid ist und B eine Gesamtmasse der Zirkonias ist,
die Sinterhilfsmittelkomponente innerhalb eines Bereichs von nicht weniger als 0,1 Massenteilen und nicht mehr als 2,0 Massenteilen pro insgesamt 100 Massenteile von A und B enthalten ist,
eine durchschnittliche Kristallkorngröße der Aluminiumoxidkristalle nicht weniger als 1,0 $\mu$m und nicht mehr als 1,5 $\mu$m beträgt,
eine durchschnittliche Kristallkorngröße der Zirconiumdioxidkristalle nicht weniger als 0,3 $\mu$m und nicht mehr als 0,5 $\mu$m beträgt, und
eine Standardabweichung der Kristallkorngröße der Aluminiumoxidkristalle nicht größer als 0,7 ist.

2. Keramiksubstrat gemäß Anspruch 1, wobei die durchschnittliche Kristallkorngröße der Aluminiumoxidkristalle nicht kleiner als 1,2 $\mu$m und nicht größer als 1,4 $\mu$m ist.

3. Keramiksubstrat gemäß Anspruch 1 oder 2, wobei ein Verhältnis/Anteil von monoklinen Kristallen in den Zirconiumdioxidkristallen nicht kleiner als 3,0 % und nicht größer als 6,0 % ist.

4. Keramiksubstrat gemäß irgendeinem der Ansprüche 1 bis 3, wobei ein Durchschnittswert von Abständen zwischen den Schwerpunkten von jeweils zwei benachbarten Zirconiumdioxidkristalle nicht kleiner als 1,8 $\mu$m und nicht größer als 3,2 $\mu$m ist.

5. Montagesubstrat, aufweisend:

das Keramiksubstrat gemäß irgendeinem der Ansprüche 1 bis 4 und
eine Metallschicht, die sich auf dem Keramiksubstrat befindet.

6. Elektronische Vorrichtung, aufweisend:

das Montagesubstrat gemäß Anspruch 5 und
eine elektronische Komponente, die sich auf der Metallschicht des Montagesubstrats befindet.

**Revendications**

1. Un substrat céramique, comprenant :

   des cristaux d'alumine ; et
   des cristaux de dioxyde de zirconium,
   dans lequel des composants sont de l'alumine, des zircones contenant un composant stabilisateur, de l'oxyde d'hafnium et de la zircone, et un composant d'aide au frittage ;
   un rapport de masse de A à B est de 89:11 à 93:7, où A est une masse d'alumine et B est une masse totale des zircones ;
   le composant d'aide au frittage est contenu dans une gamme de ne pas inférieure à 0,1 parties en masse ni supérieure à 2,0 parties en masse par total de 100 parties en masse de A et B ;
   une taille moyenne de grain cristallin des cristaux d'alumine n'est pas inférieure à 1,0 μm ni supérieure à 1,5 μm ;
   une taille moyenne de grain cristallin des cristaux de dioxyde de zirconium n'est pas inférieure à 0,3 μm ni supérieure à 0,5 μm ; et
   un écart type de la taille de grain cristallin des cristaux d'alumine n'est pas supérieur à 0,7.

2. Le substrat céramique selon la revendication 1, dans lequel la taille moyenne de grain cristallin des cristaux d'alumine n'est pas inférieure à 1,2 μm ni supérieure à 1,4 μm.

3. Le substrat céramique selon la revendication 1 ou 2, dans lequel un rapport de cristaux monocliniques dans les cristaux de dioxyde de zirconium n'est pas inférieur à 3,0 % ni supérieur à 6,0 %.

4. Le substrat céramique selon l'une quelconque des revendications 1 à 3, dans lequel une valeur moyenne de distances entre les centres de gravité de tous les deux cristaux de zircone voisins n'est pas inférieure à 1,8 μm ni supérieure à 3,2 μm.

5. Un substrat de montage comprenant :

   le substrat céramique selon l'une quelconque des revendications 1 à 4 ; et
   une couche métallique située sur le substrat céramique.

6. Un dispositif électronique comprenant :

   le substrat de montage selon la revendication 5 ; et
   un composant électronique situé sur la couche métallique du substrat de montage.

FIG. 1

FIG. 2

FIG. 3

FIG. 4

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 8195450 A